# EUROPEAN PATENT SPECIFICATION

(11) **EP 3 554 823 B1**
(45) Date of publication and mention of the grant of the patent: **30.06.2021**
(21) Application number: 17880180.9
(22) Date of filing: 14.12.2017
(51) Int. Cl.: B32B 5/22, B82B 1/00, B82Y 30/00, H01L 23/31, H01L 23/495

(54) **A BI-LAYER NANOPARTICLE ADHESION FILM**
ZWEISCHICHTIGE NANOPARTIKELHAFTFOLIE
FILM D'ADHÉSION À DEUX COUCHES DE NANOPARTICULES

(30) Priority: 14.12.2016 US 201615378236
(43) Date of publication of application: 23.10.2019
(73) Proprietor: Texas Instruments Incorporated, Dallas, TX 75265-5474 (US)
(72) Inventor: COOK, Benjamin, Stassen, Addison, TX 75001 (US); LIN, Yong, Plano, TX 75023 (US)
(74) Representative: Zeller, Andreas
(86) International application number: PCT/US2017/066495
(87) International publication number: WO 2018/112247

(56) References cited:
- WO-A1-2008/068873
- US-A1- 2005 048 758
- US-A1- 2007 001 319
- US-A1- 2007 145 606
- US-A1- 2007 163 643
- US-A1- 2007 262 432
- US-A1- 2009 047 485
- US-A1- 2009 159 121
- US-A1- 2015 243 402
- US-B2- 7 843 055

## Description

This relates generally to semiconductor devices and processes, and more particularly to the structure and fabrication of bi-layer nanoparticle adhesion films applied to packaged semiconductor devices for improving adhesion of the interface between different materials.

### BACKGROUND

Based on their functions, semiconductor packages include a variety of different materials. Metals formed as leadframes and bonds are employed for mechanical stability, and electrical and thermal conductance. Insulators, such as polymeric molding compounds, are used for encapsulations and form factors. During packaging fabrication, it is common practice to attach a plurality of semiconductor chips to a strip of a leadframe, to connect the chips to their respective leads, and then to encapsulate the assembled chips in packages. Packages protect enclosed parts against mechanical damage and environmental influences such as moisture and light.

A popular encapsulation technique is a transfer molding method. A leadframe strip with attached and connected chips is placed in a steel mold, which forms a cavity around each assembled chip. A semi-viscous thermoset polymeric compound is pressured through runners across the leadframe strip to enter each cavity through a gate. After filling the cavities, the compound is allowed to harden by polymerization. Finally, in the degating step, the compound in the runner is broken off at each gate from the compound filling the cavity.

To ensure the unity and coherence of the package, the metallic and non-metallic materials are expected to adhere to each other during the lifetime of the product. Failing adhesion allows moisture ingress into the package, causing device failure by electrical leakage and chemical corrosion. It may further lead to failure of the attachment of semiconductor chips to substrates, to breakage of wire bonds, cracking of solder bumps, and to degraded thermal and electrical energy dissipation.

Today's semiconductor technology employs a number of methods to improve adhesion between the diversified materials so that the package passes accelerated test and use conditions without delamination. The methods include chemically purifying the molding compound, activating leadframe metal surfaces (such as by plasma just before the molding process), and enhancing the affinity of leadframe metals to polymeric compounds by oxidizing the base metal. Furthermore, design features such as indentations, grooves or protrusions, overhangs and other three-dimensional features are added to the leadframe surface for improved interlocking with the package material.

Another example of known technology to increase adhesion between leadframe, chip, and encapsulation compound in semiconductor packages, is the roughening of the whole leadframe surface by chemically etching the leadframe surface after stamping or etching the pattern from a metal sheet. Chemical etching is a subtractive process using an etchant. Chemical etching creates a micro-crystalline metal surface with a roughness on the order of 1 µm or less. To roughen only one surface of the leadframe adds about 10 to 15 % cost to the non-roughened leadframe.

Yet another known method to achieve a rough surface is the use of a specialized metal plating bath, such as a nickel plating bath, to deposit a rough metal (such as nickel) layer. This method is an additive process. The created surface roughness is on the order of 1 to 10 µm. Roughening of the leadframe surface may have some unwelcome side effects. General roughening of the surface impacts wire bonding negatively, because vision systems have trouble seeing the roughened surface; the rough surface shortens capillary life; and micro-contaminants on the rough surface degrades bonding consistency. Generally, rough surfaces tend to allow more bleeding, when the resin component separates from the bulk of the chip attach compound and spreads over the surface of the chip pad. The resin bleed, in turn, can degrade moisture level sensitivity and interfere with down bonds on the chip pad. Selective roughening technique is sometimes employed, which involves reusable silicone rubber masks or gaskets; consequently, selective roughening is expensive. For example, protective masks to restrict the chemical roughening to the selected leadframe areas add about 35 to 40 % cost to the non-roughened leadframe.

The success of all these efforts has been limited, especially because the adhesive effectiveness is diminishing ever more when another downscaling step of device miniaturization is implemented. US 2007/145606 discloses a semiconductor device with semiconductor device components embedded in a plastic housing composition.

### SUMMARY

In described examples of a substrate of a first material with a surface, the surface is modified by depositing a bi-layer nanoparticle film. The film includes a nanoparticle layer of a second material on top of and in contact with the surface, and a nanoparticle layer of a third material on top of and in contact with the nanoparticle layer of the second material. The nanoparticles of the third material adhere to the nanoparticles of the second material. A substrate region adjoining surface comprises an admixture of the second material in the first material. A fourth material contacts and chemically/mechanically bonds to the nanoparticle layer of the third material.

### BRIEF DESCRIPTION OF THE DRAWINGS

FIG. 1 is a diagram summarizing the process flow of creating an additive bi-layer nanoparticle adhesion film for enhancing adhesion between objects of dissimilar material according to an embodiment.
FIG. 2 illustrates an embodiment comprising the formation of an additive layer of nanoparticles of a second material on the surface of a substrate of a first material.
FIG. 3 shows an enlargement of a portion of a syringe with a nozzle in FIG. 2, wherein the syringe is filled with a paste of nanoparticles of a second material in a solvent according to an embodiment.
FIG. 4 depicts the additive layer after sintering the nanoparticles of the second material, concurrently with diffusing second material into the substrate region adjoining the substrate surface according to an embodiment.
FIG. 5 illustrates the formation of an additive layer of nanoparticles of a third material on the surface of a layer of sintered nanoparticles of ta second material according to an embodiment.
FIG. 6 shows an enlargement of a portion of the syringe with a nozzle in FIG. 5, wherein the syringe is filled with a paste of nanoparticles of a third material in a solvent according to an embodiment.
FIG. 7 shows the encapsulation of an additive bi-layer nanoparticle adhesion film by a packaging compound, which fills any voids of an additive layer of the third material according to an embodiment.
FIG. 8 illustrates another embodiment comprising the formation of an additive layer of nanoparticles using a solvent including a mixture of nanoparticles of a second material and nanoparticles of a third material.
FIG. 9 shows an enlargement of a portion of the syringe with a nozzle in FIG. 8, wherein the syringe is filled with a paste including a mixture of nanoparticles of a second material and nanoparticles of a third material in a solvent according to an embodiment.
FIG. 10 depicts an example packaged semiconductor device having portions of its leadframe covered with a bi-layer nanoparticle adhesion film, enhancing the adhesion between the leadframe and the plastic package according to an embodiment.
FIG. 11 illustrates a conventional nanoparticle core with different hydrophobic ligand molecules, both drawn to scale.

### DETAILED DESCRIPTION OF EXAMPLE EMBODIMENTS

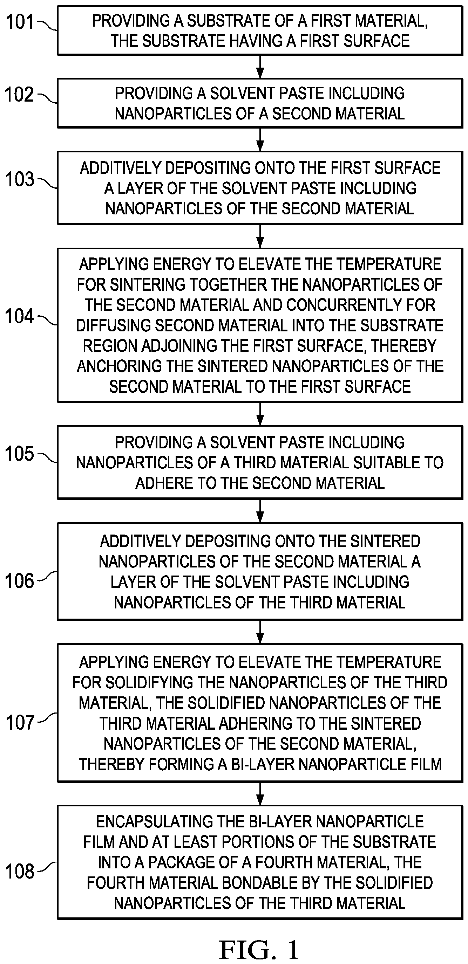

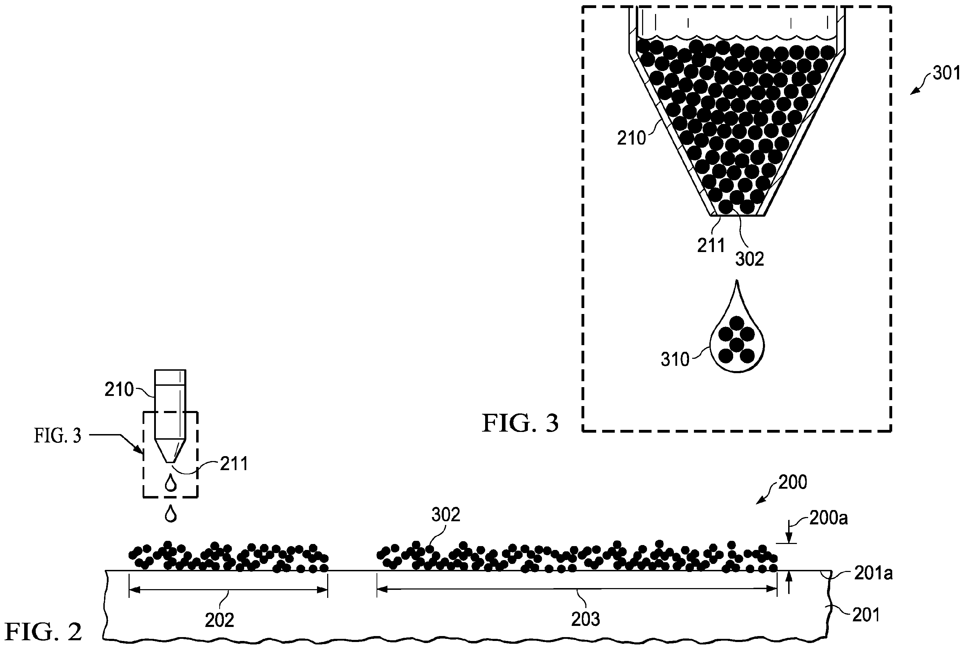

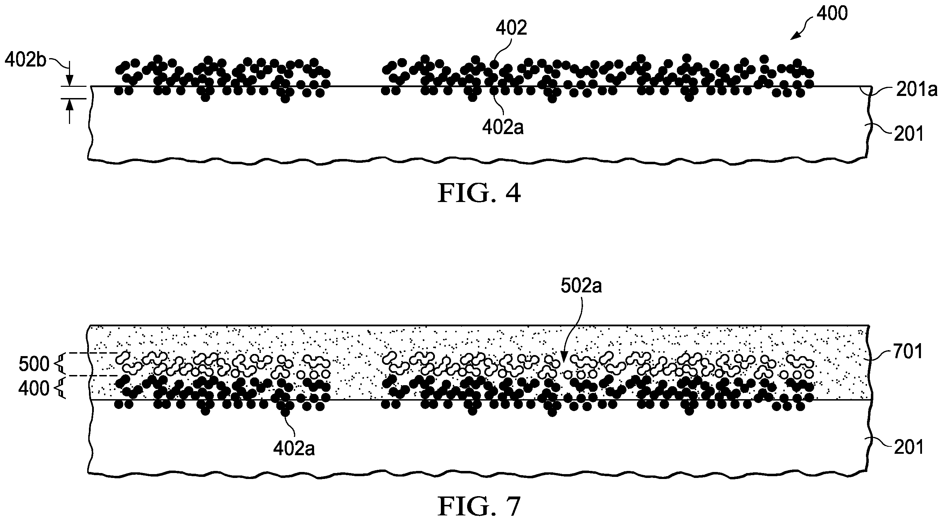

In an embodiment, a method for enhancing the adhesion and mechanical bonding between diverse materials is described. The method comprises the formation and anchoring of an additive adhesion film composed of two superimposed (or alternatively, intermeshed) nanoparticle layers between the materials. FIG. 1 is a diagram summarizing an embodiment. A material, onto which an additive film is constructed, is herein referred to as substrate, while another material, which needs adhesion to the substrate, is herein referred to as package. As examples, a substrate is denoted 201 in FIG. 2, and a package is denoted 701 in FIG. 7.

An application of the process flow shown in FIG. 1 can be applied to the fabrication technology of semiconductor devices. In semiconductor technology, the substrate usually is either a metallic leadframe or a laminated substrate composed of a plurality of alternating electrically insulating and electrically conductive layers. In process 101 of FIG. 1, a substrate is selected, which is made of a first material and has a surface extending in two dimensions.

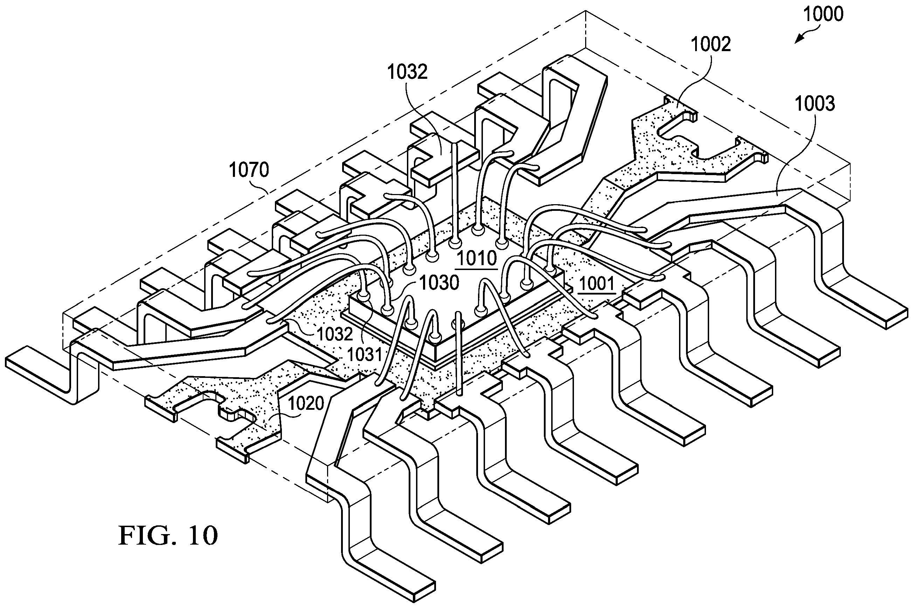

When the substrate is a leadframe (see FIG. 10), such leadframe is preferably etched or stamped from a thin sheet of base metal such as copper, copper alloy, iron-nickel alloy, aluminum, kovar™, and others, in a usual thickness range from 120 to 250 µm. As used herein, the term base metal has the connotation of starting material and does not imply a chemical characteristic. Some leadframes may have additional metal layers plated onto the complete or the partial surface areas of the base metal; examples are plated nickel, palladium, and gold layers on copper leadframes.

A leadframe provides a stable support pad (1001 in FIG. 10) for firmly positioning the semiconductor chip (1010). Further, a leadframe offers a multitude of conductive leads (1003) to bring various electrical conductors into close proximity of the chip. Any remaining gap between the tip of the leads and the chip terminals is usually bridged by bonding wires (1030). Alternatively, in flip-chip technology the chip terminals may be connected to the leads by metal bumps.

It is important that leadframe characteristics facilitate reliable adhesion to an attached chip and to packaging compounds (1070 in FIG. 10). Besides chemical affinity between the molding compound and the metal finish of the leadframe, adhesion may necessitate leadframe surface roughness, especially in view of the technical trend of shrinking package dimensions, which offers less surface area for adhesion. Also, the requirement to use lead-free solders pushes the reflow temperature range into the neighborhood of about 260 °C, making it more difficult to maintain mold compound adhesion to the leadframes at elevated temperatures.

Referring to the process flow of FIG. 1, during step 102 of the process flow a solvent paste is provided, which comprises a dispersant or solvent including nanoparticles of a second material. An example of a solvent paste is illustrated in FIG. 3 and designated 301. The nanoparticles, dissolved in the dispersant, are referred to as nanoparticles 302 of a second material. In this description, nanoparticles include spherical or other three-dimensional clusters composed of atoms or molecules, of inorganic or organic chemical compounds, of one-dimensional wires, of two-dimensional crystals and platelets, and of nanotubes.

Nanoparticles 302 may be selected from a group including metals, metal oxides, oxides, and ceramics. The metals may include gold, silver, copper, aluminum, tin, zinc, and bismuth. Metal oxides may include copper oxide, which, as a mixture of cupric and cuprous oxide with a varying ratio, is known to offer better chemical adhesion to molding compounds than copper.

During step 103 of the process flow of FIG. 1, a layer 200 of the solvent paste 301, which includes nanoparticles of the second material, is additively deposited on a surface 201a of the substrate 201 shown in FIG. 2. Layer 200 may extend over the available two-dimensional surface area, or it may cover only portions of the surface area such as islands between about 0.1 µm to 100 µm dependent on the drop size of the solvent paste.

The equipment for depositing the solvent paste includes a computer-controlled inkjet printer with a moving syringe 210 with nozzle 211, from which discrete drops 310 of the paste are released. Automated inkjet printers can be selected from a number of commercially available printers. Alternatively, a customized inkjet printer can be designed to work for specific pastes. Alternatively, any additive method can be used including inkjet printing, screen printing, gravure printing, dip coating, spray coating, and many others.

As stated, the deposited layer 200 may extend along the lateral dimensions of the substrate 201, or may include, as depicted in FIG. 2 as example lengths 202 and 203, islands extending for about 0.1 µm to 100 µm length. In metallic leadframes, layer 200 may cover the whole leadframe surface area of one or more leads, or selected parts such as the chip attach pad. Building up height from compiled drops of repeated runs of syringe 210, layer 200 may have a height 200a between about 100 nm and 500 nm, but may be thinner or considerably thicker.

During step 104 of the process flow of FIG. 1, energy is provided to elevate the temperature for sintering together the nanoparticles of the second material and concurrently for diffusing the second material into the substrate region adjoining the first surface, thereby anchoring the sintered nanoparticles of the second material to the first surface. The needed energy may be provided by a plurality of sources: thermal energy, photonic energy, electromagnetic energy, and chemical energy. When sintering together, the nanoparticles 302 are necking between the particles into a liquid network structure 402. The liquid network structure 402 is forming layer 400 in FIG. 4.

Concurrent with the sintering of the nanoparticles 402 of the second material, some second material is diffusing by atomic interdiffusion into the first material of the region adjoining the surface 201a (first surface) of substrate 201. In FIG. 4, the second material interdiffused into the region near surface 201a of substrate 201 is designated 402a. The diffusion depth is designated 402b in FIG. 4. The atomic interdiffusion into the substrate creates an interdiffusion bond, which anchors layer 400 of sintered second nanoparticles into substrate 201.

After the sintering process, the liquid network structure 402 of second material is solidified to create a solid layer 400 of second material 402. Because the hardened network structure 400 remains at the substrate surface as a solid layer, the nanoparticles 402 of the second material are structural nanoparticles.

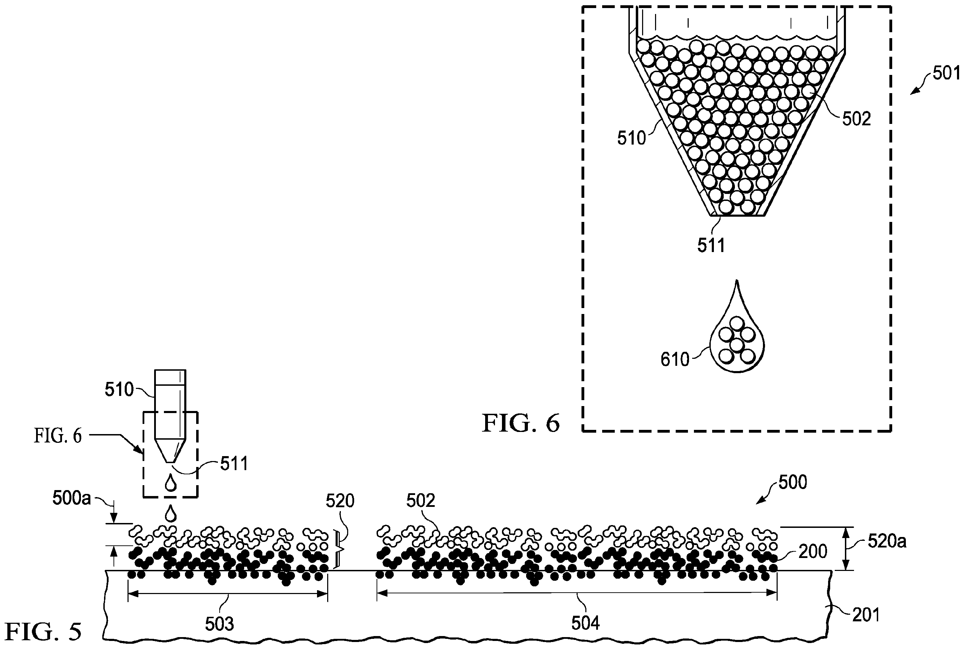

During the process step 105 of the process flow shown in FIG. 1, another solvent paste is provided, which comprises a dispersant or solvent including nanoparticles of a third material. An example of a solvent paste is illustrated in FIG. 5 and designated 501. The nanoparticles, dissolved in the dispersant, are referred to as nanoparticles 502 of a third material. The third material may be selected from a group including polymers, oxides, ceramics, metals, and metal oxides. The metals may include gold, silver, copper, aluminum, tin, zinc, and bismuth, and the metal oxides may include copper oxide, which, as a mixture of cupric and cuprous oxide with a varying ratio, is known to offer better chemical adhesion to molding compounds than copper.

In conjunction with the selection of the nanoparticles of the second material, the nanoparticles of the third material are selected so that they are operable to have adhesion to the nanoparticles of the second material. Due to intermolecular forces, the nanoparticles of the third material cling to the nanoparticles of the second material. In a related effect, an increase of surface tension, or surface energy, causes an increase of adhesion and wetting to a surface.

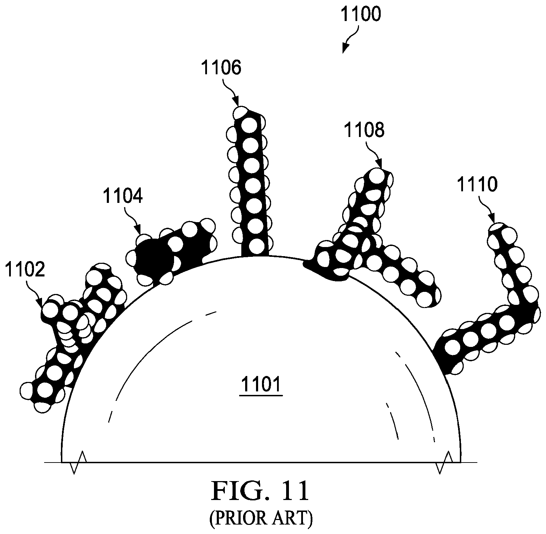

When surfaces of nanoparticles are treated so that the treated nanoparticles are enabled to perform certain desired functions, such treatment is referred to as functionalization. For example, if nanoparticles are desired to stay separate from each other, they can be treated with ligands (they are "functionalized") to prevent coagulation. In the example described in FIG. 2, it is advantageous to functionalize the surfaces of the nanoparticles of the third material for improved adhesion to the nanoparticles of the second material. FIG. 11 illustrates a nanoparticle 1100 with a core 1101 idealized as a smooth sphere of 5 nm diameter together with different hydrophobic ligand molecules drawn to scale and attached to the surface of core 1101. The ligand molecules in FIG. 11 include molecule 1102 (trioctylphosphine oxide, TOPO), molecule 1104 (triphenylphosphine, TPP), molecule 1106 (dodecanethiol, DDT), molecule 1108 (tetraoctylammonium bromide, TOAB), and molecule 1110 (oleic acid, OA).

The cores of other nanoparticles may have hydrophilic ligand molecules attached to the core surface. Examples include mercaptoacetic acid (MAA), mercaptopropionic acid (MPA), mercaptoundecanoic acid (MUA), mercaptosuccinic acid (MSA), dihydrolipic acid (DHLA), bis-sulphonated triphenylphosphine (mPEG₅-SH, mPEG₄₅-SH), and short peptide of sequence CALNN Ligand molecules such as inert molecular chains attached on the surface of the core can stabilize the nanoparticles against aggregation, while other ligand molecules attached on the surface can enhance the adhesion to objects.

As an example, for promoting covalent bonding of copper oxide (both CuO and Cu₂O) nanoparticles, molecules of siloxane, silane, or the amine-group may be attached to the core surface to functionalize copper oxide nanoparticles.

For some applications, adhesion between the layer of the third material and the layer of the second material can be achieved, when the third material is the same chemical element as the second material but has different porosity or a different compound formulation leading to a different surface function. As an example, the third material may be a compound of the amine group or the silane group of the same element as the second material or the third material may belong to a different oxide formulation, such as CuO vs. Cu₂O. As another example, the material density may be different, or the size or density of the porosity (regular vs. random configuration). As yet another example, the third material may have a different diffusion characteristic into solids along grain boundaries or lattice defects.

During step 106 of the process flow shown in FIG. 1, a layer 500 of the solvent paste 501, which includes nanoparticles of the third material, is additively deposited on layer 200 of sintered nanoparticles of the second material. The process is illustrated in FIG. 5; the thickness of layer 500 of nanoparticles of the third material is 500a. Layer 500 may extend over the available two-dimensional surface area of substrate 201, or, as depicted in FIG. 5 as example lengths 503 and 504, it may cover only portions of the surface area such as islands between about 0.1 µm to 100 µm dependent on the drop size of the solvent paste.

The equipment for the deposition includes a computer-controlled inkjet printer with a moving syringe 510 with nozzle 511, from which discrete drops 610 of the paste are discontinuously released. Automated inkjet printers can be selected from a number of commercially available printers. Alternatively, a customized inkjet printer can be designed to work for specific pastes. Alternatively, any additive method can be used including screen printing, gravure printing, flexographic printing, dip coating, spray coating, and inkjet printing comprising piezoelectric, thermal, acoustic and electrostatic inkjet printing.

As stated, the deposited layer 500 may extend along the lateral dimensions of the whole substrate 201, or may, as depicted in FIG. 5, include islands extending for about 0.1 µm to 100 µm length. In metallic leadframes, layer 500 may cover the whole leadframe surface area of only one or more leads, or selected parts such as the chip attach pad. Building up height from compiled drops of repeated runs of syringe 510, layer 500 may preferably have a height 500a between about 100 nm and 500 nm, but may be thinner or considerably thicker.

During step 107 of the process flow shown in FIG. 1, energy is provided to increase the temperature for sintering together the nanoparticles of the third material. The needed energy may be provided by a plurality of sources: thermal energy, photonic energy, electromagnetic energy, and chemical energy. When sintering together, the nanoparticles 502 are necking between the particles into a liquid network structure. In the necking connections, the surfaces of the molten particles exhibit a constricted range resembling a neck between the particles. The liquid network structure is forming layer 500 in FIG. 4. After the sintering process, the liquid network structure of third material is solidified to create a solid layer 400 of third material.

With the nanoparticles of the third material sintered, solidified, and adhering to the sintered nanoparticles of the second material, a bi-layer nanoparticle film 520 is formed. The thickness 520a of bi-layer film 520 is preferably between about 0.1 µm and 10 µm.

During step 108 of the process flow shown in FIG. 1, the solid bi-layer nanoparticle film 520, together with at least portions of the substrate 201 of first material, are encapsulated into a package of polymeric compound. The process is illustrated in FIG. 7, wherein the polymeric compound is denoted 701. A method for encapsulation by a polymeric compound is transfer molding technology using a thermoset epoxy-based molding compound. Because the compound has low viscosity at the elevated temperature during the molding process, the polymeric compound can readily fill any pores/voids 502a in the layer 500 of third material. The filling of the pores/voids by polymeric material takes place for any pores/voids, whether they are arrayed in an orderly pattern or in a random distribution, and whether they are shallow or in a random three-dimensional configuration including pores/voids resembling spherical caverns with narrow entrances.

After the compound has polymerized and cooled down to ambient temperature, the polymeric compound 701 is hardened in the package and in the pores/voids. After hardening of the plastic material, the polymeric-filled pores/voids represent an anchor of the package in the nanoparticle layer 500, giving strength to the interface of package (fourth material) and the bi-layer nanoparticle film (third material). Also, as described hereinabove, layer 500 has adhesion to nanoparticle layer 400, giving the bi-layer film strength. In turn, layer 400 is anchored in metallic substrate 201 by metal interdiffusion 402a, giving the interface of the bi-layer film to the substrate strength. As an overall result, the bi-layer nanoparticle film improves the adhesion between the plastic package 701 and the metallic substrate 201. Adhesion improvements of an order of magnitude have been measured.

In addition to mechanical adhesion between bodies, the overall adhesion between two different materials can be improved by chemical adhesion. Consequently, the nanoparticles of the second material and third material can be chosen to enhance chemical adhesion. As an example, copper oxide nanoparticles have better chemical bonding to polymeric molding compounds than gold nanoparticles.

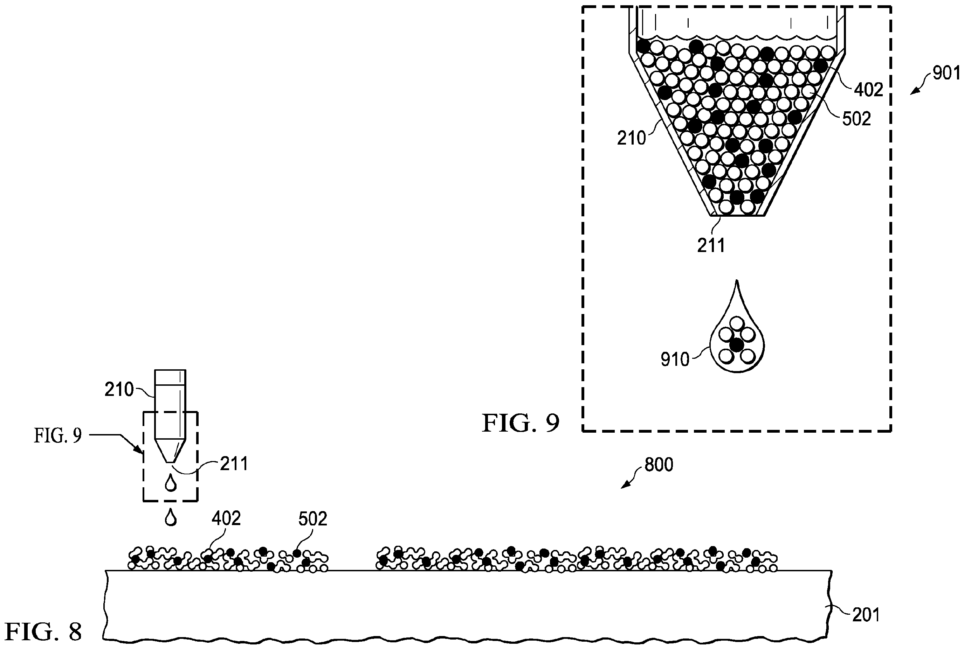

Another embodiment is a nanoparticle layer as depicted in FIG. 8, which mixes the nanoparticles 402 of the second material and the nanoparticles 502 of the third material into a single homogeneous layer 800. Joint layer 800 improves the adhesion between substrate 201 and package 701 by averaging the adhesion at the two interfaces substrate 201 to layer 800, and package 701 to layer 800.

The fabrication process for layer 800, as illustrated in FIGS. 8 and 9, is analogous to the fabrication processes described hereinabove for creating the nanoparticle layers 400 and 500. A computer-controlled inkjet printer is used with the solvent paste 901 comprising a mixture of nanoparticles 402 of the second material and nanoparticles 502 of the third material.

The method for adhesion improvement between two objects by a sintered semi-homogeneous nanoparticle layer of two nanoparticle materials begins by providing an object of a first material and an object of a fourth material. Then, a solvent paste is provided, which includes a semi-homogeneous mixture of nanoparticles of a second material and nanoparticles of a third material. The nanoparticles of the second material are able to form diffusion bonds to the first material by molecular diffusion into the surface-near region of the substrate made of the first material. The nanoparticles of the third material form adhesion bonds by intermolecular forces to the nanoparticles of the second material, and further form to the object of the fourth material chemical bonds due to electrical forces and/or mechanical bonds due to filling of pores/voids.

Using a computerized inkjet printing technique for the next process, a layer of the semi-homogeneous mixture of the solvent paste is additively deposited on the surface of the object of the first material. Energy is then applied to elevate the temperature for sintering together the nanoparticles of the second and the third materials, forming a sintered nanoparticle layer, and for concurrently diffusing second material into the region adjoining the surface of the object of the first material.

Next, the object of the fourth material is brought into contact with the sintered nanoparticle layer so that the chemical and/or mechanical bonding is actualized; the object of the fourth material is bonded to the nanoparticles of the third material.

FIG. 10 illustrates an example embodiment of the enhanced adhesion by a bi-layer nanoparticle adhesion film in an example semiconductor device, which includes a metallic leadframe and a plastic package. This example embodiment is a semiconductor device 1000 with a leadframe including a pad 1001 for assembling a semiconductor chip 1010, tie bars 1002 connecting pad 1001 to the sidewall of the package, and a plurality of leads 1003. In this description, the tie bars may be referred to as straps. The chip terminals are connected to the leads 1003 by bonding wires 1030, which commonly include ball bond 1031 and stitch bond 1032. In the example of FIG. 10, leads 1003 are shaped as cantilevered leads; in other embodiments, the leads may have the shape of flat leads as used in Quad Flat No-Lead (QFN) devices or in Small Outline No-Lead (SON) devices. Along their longitudinal extension, straps 1002 of the example device in FIG. 10 include bendings and steps, because pad 1001 and leads 1003 are not in the same plane. In other devices, straps 1002 are flat and planar, because pad 1001 and leads 1003 are in the same plane.

In FIG. 10, portions of the leadframe are marked by dashing 1020, which include in a bi-layer film made of nanoparticles. The film may include voids of random distribution and random three-dimensional configurations. Because the example device 1000 includes a package 1070 for encapsulating chip 1010 and wire bonds 1030, any voids of the bi-layer film are filled by the polymeric compound. Package 1070 is made of a polymeric compound such as an epoxy-based thermoset polymer, formed in a molding process, and hardened by a polymerization process. The adhesion between the polymeric compound of package 1070 and the leadframe is improved by the bi-layer nanoparticle film. Other devices may have more and larger areas of the leadframe covered by the porous bi-layer nanoparticle film.

In semiconductor technology, example embodiments are applicable to active semiconductor devices with low and high pin counts, such as transistors and integrated circuits, and also to combinations of active and passive components on a leadframe pad.

As another example, example embodiments are applicable to silicon-based semiconductor devices, and also to devices using gallium arsenide, gallium nitride, silicon germanium, and any other semiconductor material employed in industry. Further, example embodiments are applicable to leadframes with cantilevered leads and to QFN and SON type leadframes.

As another example, in addition to leadframes, example embodiments are applicable to laminated substrates and any other substrate or support structure to be bonded to a non-metallic body.

Modifications are possible in the described embodiments, and other embodiments are possible, within the scope of the claims.

## Claims

1. A device comprising:
a substrate of a first material, the substrate having a surface;
a nanoparticle layer of a second material on top of and in contact with the surface of the substrate, a substrate region adjoining the substrate surface comprising an admixture of the second material in the first material;
a nanoparticle layer of a third material on top of and in contact with the nanoparticle layer of the second material, the nanoparticles of the third material adhering to the nanoparticles of the second material; and
a package of a fourth material, the fourth material contacted to, and bonded to, the nanoparticle layer of the third material, the fourth material filling any voids in the layer of third material.

2. The device of claim 1 wherein the substrate of the first material is a laminated substrate including metallic regions.

3. The device of claim 1 wherein the substrate of the first material is one or more surfaces on a metallic leadframe.

4. The device of claim 3 wherein the first material of the metallic leadframe is selected from a group including copper, copper alloys, aluminum, aluminum alloys, iron-nickel alloys, and Kovar™; optionally wherein the metallic leadframe further includes plated layers selected from a group including nickel, palladium, gold, and tin.

5. The device of claim 1 wherein the fourth material includes a polymeric compound such as an epoxy-based molding compound.

6. The device of claim 1 wherein the adhering of the nanoparticles of the third material to the nanoparticles of the second material is based on intermolecular forces between the nanoparticles.

7. The device of claim 1 wherein the bonding of the fourth material to the nanoparticle layer of the third material is based on a) intermingling of the fourth material with the third material; or b) chemical bonding.

8. A method for substrate modification comprising:
providing a substrate of a first material, the substrate having a first surface;
additively depositing onto the first substrate a layer of a solvent paste including nanoparticles of a second material;
applying energy to the first solvent paste to increase the temperature to sinter together the nanoparticles of the second material and concurrently for diffusing the second material into a substrate region adjoining the first surface;
additively depositing onto the sintered nanoparticles of the second material a layer of a second solvent paste, the second solvent paste including nanoparticles of a third material; and
applying energy to the second solvent paste to increase the temperature to solidify the nanoparticles of the third material, the solidified nanoparticles of the third material adhering to the sintered nanoparticles of the second material, thereby forming a bi-layer nanoparticle film.

9. The method of claim 8 wherein the substrate is selected from a group including metallic substrates, metallic leadframes used for semiconductor devices, and laminated substrates including metallic layers alternating with insulating layers.

10. The method of claim 8 wherein the first material is selected from a group including copper, copper alloys, aluminum, aluminum alloys, iron-nickel alloys, and Kovar™.

11. The method of claim 8 wherein the method of additively depositing is selected from a group including screen printing, flexographic printing, gravure printing, dip coating, spray coating, and inkjet printing comprising piezoelectric, thermal, acoustic, and electrostatic inkjet printing.

12. The method of claim 8 wherein the energy for sintering the second nanoparticles is selected from a group including thermal energy, photonic energy, electromagnetic energy, and chemical energy.

13. A method for enhancing adhesion of packaged semiconductor devices, comprising the steps of the method for substrate modification according to claim 8 and further comprising:
encapsulating the bi-layer nanoparticle film and at least portions of the substrate in a fourth material, the fourth material chemically bondable to the solidified nanoparticles of the third material.

14. The method of claim 13 wherein the substrate is a metallic leadframe for use in semiconductor devices with the first material selected from a group including copper, copper alloys, aluminum, aluminum alloys, iron-nickel alloys, and Kovar™.

15. The method of claim 10 or 14 wherein the first material includes a plated layer of a metal selected from a group including tin, silver, nickel, palladium, and gold.

16. The device of claim 1 or the method of claim 8 or 13 wherein the second material is selected from a group including metals, metal oxides, oxides, and ceramics.

17. The device of claim 1 or the method of claim 8 or 13 wherein the third material is selected from a group including polymers, oxides, ceramics, metals, and metal oxides.

18. The method of claim 13 further including, before the process of encapsulating, the process of assembling a semiconductor chip on the substrate so that the chip will be positioned inside the package after the process of encapsulating.

## Patentansprüche

1. Vorrichtung, umfassend:
ein Substrat aus einem ersten Material, wobei das Substrat eine Fläche aufweist;
eine Nanopartikelschicht aus einem zweiten Material oben auf und in Kontakt mit der Fläche des Substrats, wobei ein Substratbereich, der an die Substratfläche angrenzt, eine Beimischung aus dem zweiten Material im ersten Material umfasst;
eine Nanopartikelschicht aus einem dritten Material oben auf und im Kontakt mit der Nanopartikelschicht aus dem zweiten Material, wobei die Nanopartikel aus dem dritten Material an den Nanopartikeln aus dem zweiten Material haften; und
ein Gehäuse aus einem vierten Material, wobei das vierte Material mit der Nanopartikelschicht aus dem dritten Material in Kontakt ist und damit verbunden ist, wobei das vierte Material eventuelle Hohlräume in der Schicht aus dem dritten Material füllt.

2. Vorrichtung nach Anspruch 1, wobei das Substrat aus dem ersten Material ein Schichtsubstrat mit Metallbereichen ist.

3. Vorrichtung nach Anspruch 1, wobei das Substrat aus dem ersten Material eine oder mehrere Flächen auf einem Leiterrahmen aus Metall ist bzw. sind.

4. Vorrichtung nach Anspruch 3, wobei das erste Material des Leiterrahmens aus Metall aus einer Gruppe ausgewählt ist, die Kupfer, Kupferlegierungen, Aluminium, Aluminiumlegierungen, Eisen-Nickel-Legierungen und Kovar™ umfasst; wobei optional der Leiterrahmen aus Metall ferner plattierte Schichten aufweist, die aus einer Gruppe ausgewählt sind, die Nickel, Palladium, Gold und Zinn umfasst.

5. Vorrichtung nach Anspruch 1, wobei das vierte Material eine Polymerverbindung wie eine Spritzverbindung auf Epoxidbasis aufweist.

6. Vorrichtung nach Anspruch 1, wobei das Haften der Nanopartikel aus dem dritten Material an den Nanopartikeln aus dem zweiten Material auf zwischenmolekularen Kräften zwischen den Nanopartikeln basiert.

7. Vorrichtung nach Anspruch 1, wobei das Verbinden des vierten Materials mit der Nanopartikelschicht aus dem dritten Material auf a) einem Vermischen des vierten Materials mit dem dritten Material; oder b) auf chemischem Verbinden basiert.

8. Verfahren zur Substratmodifizierung, umfassend:
Bereitstellen eines Substrats aus einem ersten Material, wobei das Substrat eine erste Fläche aufweist;
additives Abscheiden einer Schicht aus einer Lösemittelpaste, die Nanopartikel aus einem zweiten Material aufweist, auf dem ersten Substrat;
Anwenden von Energie auf die erste Lösemittelpaste zwecks Temperaturerhöhung zum Zusammensintern der Nanopartikel aus dem zweiten Material und gleichzeitig zwecks Diffusion des zweiten Materials in einen Substratbereich hinein, der an die erste Fläche angrenzt;
additives Abscheiden einer Schicht aus einer zweiten Lösemittelpaste auf den gesinterten Nanopartikeln aus dem zweiten Material, wobei die zweite Lösemittelpaste Nanopartikel aus einem dritten Material aufweist; und
Anwenden von Energie auf die zweite Lösemittelpaste zwecks Temperaturerhöhung zum Verfestigen der Nanopartikel aus dem dritten Material, wobei die verfestigten Nanopartikel aus dem dritten Material an den gesinterten nanopartikeln aus dem zweiten Material haften, wodurch ein zweischichtiger Nanopartikelfilm entsteht.

9. Verfahren nach Anspruch 8, wobei das Substrat aus einer Gruppe ausgewählt wird, die Metallsubstrate, Leiterrahmen aus Metall, die für Halbleiterbauelemente eingesetzt werden, und Schichtsubstrate umfasst, die Metallschichten aufweisen, die sich mit Isolierschichten abwechseln.

10. Verfahren nach Anspruch 8, wobei das erste Material aus einer Gruppe ausgewählt wird, die Kupfer, Kupferlegierungen, Aluminium, Aluminiumlegierungen, Eisen-Nickel-Legierungen und Kovar™ umfasst.

11. Verfahren nach Anspruch 8, wobei das Verfahren des additiven Abscheidens aus einer Gruppe ausgewählt wird, die Siebdruck, Flexodruck, Tiefdruck, Tauchbeschichten, Sprühbeschichten und Inkjetdruck umfasst, das den Piezo-Inkjet, den Thermo-Inkjet, den akustischen und den elektrostatischen Inkjetdruck umfasst.

12. Verfahren nach Anspruch 8, wobei die Energie zum Sintern der zweiten Nanopartikel aus einer Gruppe ausgewählt wird, die Wärmeenergie, Lichtenergie, elektromagnetische Energie und chemische Energie umfasst.

13. Verfahren zum Verbessern der Haftung gehäuster Halbleiterbauelemente, das die Schritte des Verfahrens zur Substratmodifizierung nach Anspruch 8 umfasst und ferner umfasst:
Verkapseln des zweischichtigen Nanopartikelfilms und zumindest von Abschnitten des Substrats in einem vierten Material, wobei das vierte Material chemisch mit den verfestigten Nanopartikeln aus dem dritten Material verbindbar ist.

14. Verfahren nach Anspruch 13, wobei das Substrat ein Leiterrahmen aus Metall zur Verwendung in Halbleiterbauelementen ist, wobei das erste Material aus einer Gruppe ausgewählt wird, die Kupfer, Kupferlegierungen, Aluminium, Aluminiumlegierungen, Eisen-Nickel-Legierungen und Kovar™ umfasst.

15. Verfahren nach Anspruch 10 oder 14, wobei das erste Material eine plattierte Schicht aus einem Metall aufweist, das aus einer Gruppe ausgewählt wird, die Zinn, Silber, Nickel, Palladium und Gold umfasst.

16. Vorrichtung nach Anspruch 1 oder Verfahren nach Anspruch 8 oder 13, wobei das zweite Material aus einer Gruppe ausgewählt ist, die Metalle, Metalloxide, Oxide und Keramik umfasst.

17. Vorrichtung nach Anspruch 1 oder Verfahren nach Anspruch 8 oder 13, wobei das dritte Material aus einer Gruppe ausgewählt ist, die Polymere, Oxide, Keramik, Metalle und Metalloxide umfasst.

18. Verfahren nach Anspruch 13, das ferner vor dem Prozess des Verkapselns den Prozess des Montierens eines Halbleiterchips auf dem Substrat umfasst, damit sich der Chip nach dem Prozess des Verkapselns in dem Gehäuse befindet.

## Revendications

1. Dispositif comprenant :
un substrat d'un premier matériau, le substrat ayant une surface ;
une couche de nanoparticules d'un deuxième matériau au-dessus de et en contact avec la surface du substrat, une région de substrat jouxtant la surface de substrat comprenant un mélange du deuxième matériau dans le premier matériau ;
une couche de nanoparticules d'un troisième matériau au-dessus de et en contact avec la couche de nanoparticules du deuxième matériau, les nanoparticules du troisième matériau adhérant aux nanoparticules du deuxième matériau ; et
un boîtier d'un quatrième matériau, le quatrième matériau étant mis en contact avec et lié à la couche de nanoparticules du troisième matériau, le quatrième matériau remplissant tous les vides dans la couche de troisième matériau.

2. Dispositif de la revendication 1 dans lequel le substrat du premier matériau est un substrat stratifié comportant des régions métalliques.

3. Dispositif de la revendication 1 dans lequel le substrat du premier matériau est une ou plusieurs surfaces sur une grille de connexion métallique.

4. Dispositif de la revendication 3 dans lequel le premier matériau de la grille de connexion métallique est choisi dans un groupe incluant le cuivre, les alliages de cuivre, l'aluminium, les alliages d'aluminium, les alliages fer-nickel et le Kovar™, éventuellement dans lequel la grille de connexion métallique comporte en outre des couches plaquées choisies dans un groupe incluant le nickel, le palladium, l'or et l'étain.

5. Dispositif de la revendication 1 dans lequel le quatrième matériau comporte un composé polymère tel qu'un composé de moulage à base de résine époxy.

6. Dispositif de la revendication 1 dans lequel l'adhérence des nanoparticules du troisième matériau aux nanoparticules du deuxième matériau est basée sur des forces intermoléculaires entre les nanoparticules.

7. Dispositif de la revendication 1 dans lequel la liaison du quatrième matériau à la couche de nanoparticules du troisième matériau est basée sur a) une imbrication du quatrième matériau avec le troisième matériau, ou b) une liaison chimique.

8. Procédé de modification de substrat comprenant :
l'obtention d'un substrat d'un premier matériau, le substrat ayant une première surface ;
le dépôt additif sur le premier substrat d'une couche d'une pâte de solvant comportant des nanoparticules d'un deuxième matériau ;
l'application d'énergie à la première pâte de solvant pour augmenter la température pour fritter ensemble les nanoparticules du deuxième matériau et simultanément pour faire diffuser le deuxième matériau à l'intérieur d'une région de substrat jouxtant la première surface ;
le dépôt additif sur les nanoparticules frittées du deuxième matériau d'une couche d'une deuxième pâte de solvant, la deuxième pâte de solvant comportant des nanoparticules d'un troisième matériau ; et
l'application d'énergie à la deuxième pâte de solvant pour augmenter la température pour solidifier les nanoparticules du troisième matériau, les nanoparticules solidifiées du troisième matériau adhérant aux nanoparticules frittées du deuxième matériau, formant ainsi un film de nanoparticules bicouche.

9. Procédé de la revendication 8 dans lequel le substrat est choisi dans un groupe incluant les substrats métalliques, les grilles de connexion métalliques utilisées pour les dispositifs semi-conducteurs, et les substrats stratifiés comportant des couches métalliques alternant avec des couches isolantes.

10. Procédé de la revendication 8 dans lequel le premier matériau est choisi dans un groupe incluant le cuivre, les alliages de cuivre, l'aluminium, les alliages d'aluminium, les alliages fer-nickel et le Kovar™.

11. Procédé de la revendication 8, le procédé de dépôt additif étant choisi dans un groupe incluant la sérigraphie, l'impression flexographique, l'impression en creux, le revêtement au trempé, le revêtement par pulvérisation, et l'impression par jet d'encre comprenant l'impression par jet d'encre piézoélectrique, thermique, acoustique et électrostatique.

12. Procédé de la revendication 8 dans lequel l'énergie pour le frittage des deuxièmes nanoparticules est choisie dans un groupe incluant l'énergie thermique, l'énergie photonique, l'énergie électromagnétique et l'énergie chimique.

13. Procédé d'amélioration de l'adhérence de dispositifs semi-conducteurs mis en boîtier, comprenant les étapes du procédé de modification de substrat selon la revendication 8 et comprenant en outre :
l'encapsulation du film de nanoparticules bicouche et au moins de portions du substrat dans un quatrième matériau, le quatrième matériau pouvant être lié chimiquement aux nanoparticules solidifiées du troisième matériau.

14. Procédé de la revendication 13 dans lequel le substrat est une grille de connexion métallique à utiliser dans des dispositifs semi-conducteurs avec le premier matériau choisi dans un groupe incluant le cuivre, les alliages de cuivre, l'aluminium, les alliages d'aluminium, les alliages fer-nickel et le Kovar™.

15. Procédé de la revendication 10 ou 14 dans lequel le premier matériau comporte une couche plaquée d'un métal choisi dans un groupe incluant l'étain, l'argent, le nickel, le palladium et l'or.

16. Dispositif de la revendication 1 ou procédé de la revendication 8 ou 13 dans lesquels le deuxième matériau est choisi dans un groupe incluant les métaux, les oxydes métalliques, les oxydes et les céramiques.

17. Dispositif de la revendication 1 ou procédé de la revendication 8 ou 13 dans lesquels le troisième matériau est choisi dans un groupe incluant les polymères, les oxydes, les céramiques, les métaux et les oxydes métalliques.

18. Procédé de la revendication 13 comportant en outre, avant le processus d'encapsulation, le processus d'assemblage d'une puce semi-conductrice sur le substrat de telle sorte que la puce sera positionnée à l'intérieur du boîtier après le processus d'encapsulation.
